# EUROPEAN PATENT SPECIFICATION

(11) **EP 0 281 235 B1**
(45) Date of publication and mention of the grant of the patent: **14.07.1993**
(21) Application number: 88300586.0
(22) Date of filing: 25.01.1988
(51) Int. Cl.: H01L 21/82, H01L 21/285, H01L 27/06, H01L 29/72

(54) **Bipolar transistor fabrication utilizing CMOS techniques**
Verfahren zum Herstellen eines bipolaren Transistors unter Verwendung von CMOS-Techniken
Procédé pour fabriquer un transistor bipolaire utilisant des technologies de type CMOS

(30) Priority: 30.01.1987 US 8906
(43) Date of publication of application: 07.09.1988
(73) Proprietor: TEXAS INSTRUMENTS INCORPORATED, Dallas Texas 75265 (US)
(72) Inventor: Spratt, David, Plano Texas 75075 (US); Shah, Rajiv R., Plano Texas 75075 (US)
(74) Representative: Abbott, David John

(56) References cited:
- EP-A- 0 151 347
- EP-A- 0 170 250
- US-A- 4 492 008
- US-A- 4 536 945
- JOURNAL OF VACUUM SCIENCE & TECHNOLOGY B, vol. 3, no. 6, November/December 1985, pages 1715-1724, American Vacuum Society, Woodbury, New York, US; Y. KOH et al.: "Self-aligned TiSi2 for bipolar applications"

## Description

The present invention relates in general to silicon semiconductor processing, and more particularly relates to the fabrication of bipolar transistor structures utilizing CMOS fabrication techniques.

Bipolar transistors and MOSFET transistors represent two different families of semiconductor devices which each have distinct advantages over the other. The operation and structure of these semiconductor families have traditionally differed, and thus have experienced different development routes to exploit the individual advantages. For example, bipolar transistors are well suited for use in high power, high speed, digital and analog applications. On the other hand, MOSFET transistor devices, including PMOS and NMOS transistors which form CMOS devices, are well suited for low power and high packing density applications.

The electrical operation of a bipolar transistor involves both minority and majority carriers, and has traditionally been fabricated in a manner different from CMOS transistor circuits which depend upon current flow involving majority carriers. In addition, because the operating characteristics of bipolar transistors depend upon the lateral geometry, as well as the vertical geometry of semiconductor regions, the fabrication thereof has traditionally taken a different route then that of CMOS transistors, which are lateral surface-operating devices.

With the current trend toward a large scale integration of semiconductor circuits, it has become advantageous to integrate bipolar circuits and MOSFET circuits into the same chip. In this manner, many MOSFET circuits can be arranged in a small wafer area and utilized to perform an electrical function, while the current driving capabilities of bipolar transistors can be used as the drivers for such MOSFET circuits. Many other applications exist in which the advantages of both MOSFET and bipolar devices can be combined into a single integrated circuit chip to provide an overall improved performance.

The initial integration of bipolar circuits and MOSFET circuits involved conventional process steps to form the MOSFET devices, as well as conventional steps to form the bipolar devices. Very few processing steps were shared between the fabrication of each such device type, and thus the overall process was complex, lengthy, costly and susceptible to low production yields. Because of the increased importance of integrating bipolar and CMOS devices, many attempts have been made to develop processes whereby various structures of both types of devices can be fabricated simultaneously such that the total number of processing steps are minimized, and the technologies are brought into correspondence, without compromising the performance or advantages inherent in each type of device.

From the foregoing it can be appreciated that a need exists for an improved bipolar transistor device which can be fabricated with process steps highly compatible with those of MOSFET devices. There is an associated need for a bipolar device, and method of fabrication thereof, which results in a transistor occupying less wafer area and improved performance.

In the Journal of Vacuum Science Technology B, Volume 3, No. 6, Nov/Dec 1985, pages 1715-1724, there is a paper entitled "Self-aligned TiSi₂ for Bipolar Applications" by Y. Koh, F. Chien and M. Vora, in which there is described a process for making a vertical bipolar transistor having a collector formed by a well of n⁺ conductivity type silicon in a silicon substrate with a p conductivity type implant in part of the surface of the well forming the base of the transistor. The emitter of the transistor is formed by diffusion from an n type doped polycrystalline silicon connection layer on part of the surface of the base implant. Doped polycrystalline silicon is also used for the collector and base connections. A technique is described for the self-aligned formation of titanium silicide on the polycrystalline silicon connections in the course of which passivation oxide is formed on the exposed silicon and the walls of the polycrystalline silicon connections.

According to a first aspect of the present invention there is provided a method of fabricating a bipolar transistor, comprising the steps of
forming a semiconductor well of a first conductivity type at the face of a silicon semiconductor body;
forming a semiconductor base region of a second conductivity type in the surface of said semiconductor well;
forming a polycrystalline silicon emitter structure of said first conductivity type in contact with said semiconductor base region, said emitter structure having sidewalls, and being provided with an impurity of said first conductivity type;
forming insulation on said sidewalls of said polycrystalline silicon emitter structure;
forming a semiconductor collector region of a first conductivity type in a first region of said well and self-aligned with respect to said insulation for said emitter structure;
forming a semiconductor extrinsic base region of said second conductivity type in a second region of said well and self-aligned with respect to said insulation for said emitter structure, said extrinsic base region being contiguous with said semiconductor base region; and
diffusing an impurity of said first conductivity type from said polycrystalline silicon emitter structure into said base region so as to form therein a semi-conductor emitter region of said first conductivity type.

According to a second aspect of the present invention there is provided a silicon bipolar transistor, comprising:
a semiconductor well of the first conductivity type;
a conductive polycrystalline silicon strip overlying said well and extending substantially from one side thereof to the other, one side of said polycrystalline silicon strip extending laterally beyond said semiconductor well ;
a semiconductor intrinsic base region of a second conductivity type underlying said polycrystalline silicon strip;
a semiconductor emitter region in contact with said polycrystalline silicon emitter strip and formed in said intrinsic base region;
an extrinsic base region and a collector region formed on opposing sides of said polycrystalline silicon emitter strip, said extrinsic base region and said collector region being formed in electrical contact with said intrinsic base region; and
an insulation layer between said polycrystalline silicon emitter strip and said intrinsic base region and an opening in said insulation layer through which said polycrystalline silicon emitter strip is formed in contact with said base region.

According to a third aspect of the present invention there is provided a silicon lateral bipolar transistor having regions of alternate conductivity, comprising:
an impurity well of a first conductivity type;
a semiconductor base region of a second conductivity type formed in said impurity well of said first conductivity type;
a semiconductor emitter region of said first conductivity type formed within said base region;
a polycrystalline silicon conductor in electrical contact with said emitter region;
silicon oxide formed on sidewalls of said polycrystalline silicon conductor;
a semiconductor collector region of said first conductivity type formed in said impurity well and self-aligned with said sidewall insulation; and
an extrinsic base region of said conductivity type formed in said impurity well and self-aligned with said sidewall insulation;
wherein said collector region and said extrinsic base region are formed on opposing sides of said polycrystalline silicon conductor.

According to a fourth aspect of the present invention there is provided a method of forming self-aligned semiconductor regions in a bipolar transistor, comprising:
forming a semiconductor base region in the face of a silicon substrate;
forming an insulator layer having an opening on the semiconductor base region;
forming a doped polycrystalline silicon layer overlying said insulator layer and in contact with said base region (54) through said opening to define an emitter region, said polycrystalline silicon layer having an edge extending laterally beyond said emitter region;
forming a second insulator layer on said edge of said polycrystalline silicon layer;
forming a collector region in the face of said substrate aligned with said second insulator layer; and
diffusing the dopant of said polycrystalline silicon layer into said base region to form said emitter region.

In accordance with the present invention, the disclosed bipolar device structure and method of fabrication thereof reduces or eliminates the disadvantages and the shortcomings associated with the corresponding prior art devices and processing techniques. According to the invention, various features of the bipolar device are fabricated at the same time as structures of MOSFET devices. Not only are the process steps of the invention optimized in forming bipolar and MOSFET devices, but the fabrication of a small area bipolar transistor is also made possible.

In the preferred form of the invention, a bipolar transistor N-well is formed in a P-substrate in a manner similar to the formation of a semiconductor well utilized in forming a P-channel MOSFET device. The N-wells are isolated by a thick field oxide or trenches using conventional silicon processing techniques. A thin gate oxide is then grown over the surface of the wafer, covering the bipolar and MOSFET transistor wells. A thin layer of polysilicon is then deposited over the thin gate oxide. The bipolar transistor N-well is patterned, and implanted to form a P-type intrinsic base region. An opening is formed through the thin polysilicon and gate oxide to the intrinsic base region. A layer of polycrystalline silicon (hereinafter polysilicon) is deposited over the surface of the wafer and implanted to form gate conductors for the MOSFET transistors, and a polyemitter structure for the bipolar transistor. The doped polysilicon makes contact with the intrinsic base region through the gate oxide opening. The gate and polyemitter structures are further processed by depositing thereover a silicon dioxide (hereinafter silicon oxide) insulation and anisotropically etching the same downwardly to form oxide sidewalls on the polysilicon emitter and gate structures. The sidewall oxide on the polysilicon gate structures facilitates the formation of a lightly doped drain region in the N-channel MOSFET transistor. In the bipolar transistor, the sidewall oxide the polyemitter facilitates the spacing of a collector region and an extrinsic base region from the semiconductor emitter region.

The wafer is masked, patterned and implanted to form an N+ collector region in the bipolar transistor area, and source and drain regions in the NMOS transistor area. In like manner, the wafer is processed to form implanted P+ regions, defining an extrinsic semiconductor base region in the bipolar transistor, and corresponding source and drain regions in the PMOS transistors. The source and drain regions of the MOSFET devices are self aligned to the corresponding gate conductors, and the collector and extrinsic base of the bipolar device are self aligned to the polyemitter.

In accordance with MOSFET fabrication techniques, the source, drain and gate conductor structures are silicided, together with the extrinsic base, collector and polyemitter structures of the bipolar transistor. During wafer processing, the temperature thereof is elevated sufficiently to drive the N-type impurities in the polyemitter through the gate oxide opening and into the base region. A buried emitter is thereby formed. Subsequent insulation, metalization and passivation processing is conducted to connect the various transistor structures together and to protect the completed wafer from the environment.

In another embodiment of the invention, a walled emitter structure, rather than a nested structure, can also be constructed using processing steps compatible with MOSFET device fabrication. With the walled type of emitter structure, a highly compact device can be constructed.

In yet another embodiment of the invention, a portion of the N-well area of the bipolar transistor is formed at the face of the semiconductor body adjacent a portion of the extrinsic base. Formed over the contiguous N and P semiconductor areas is a titanium silicide, thereby forming a Schottky barrier diode. The Schottky diode is constructed in parallel across the base and collector junction of the bipolar transistor, thereby resulting in a Schottky-clamped transistor.

Further features and advantages will become more apparent from the following and more particular description of the various embodiments of the invention, as illustrated in the accompanying drawings in which like reference characters generally refer to the same parts, areas and regions throughout the views, and in which:
FIGURES 1 - 13 are cross-sectional views of a semiconductor wafer which illustrate the various fabrication steps according to the invention;
FIGURE 14 is a top view, or layout, of a nested emitter bipolar device illustrated in FIGURE 13;
FIGURE 15 is a cross-sectional view of a bipolar device employing a walled emitter structure;
FIGURE 16 is a top view of the walled emitter bipolar transistor of FIGURE 15; and
FIGURE 17 is a cross-sectional view of a Schottky-clamped bipolar transistor constructed according to the principles and concepts of the invention.

As described herein, the invention is disclosed in terms of the fabrication of an exemplary NPN bipolar transistor. Reference will be made to corresponding conventional steps for fabricating CMOS transistors, the particularities of which are not shown pictorially herein.

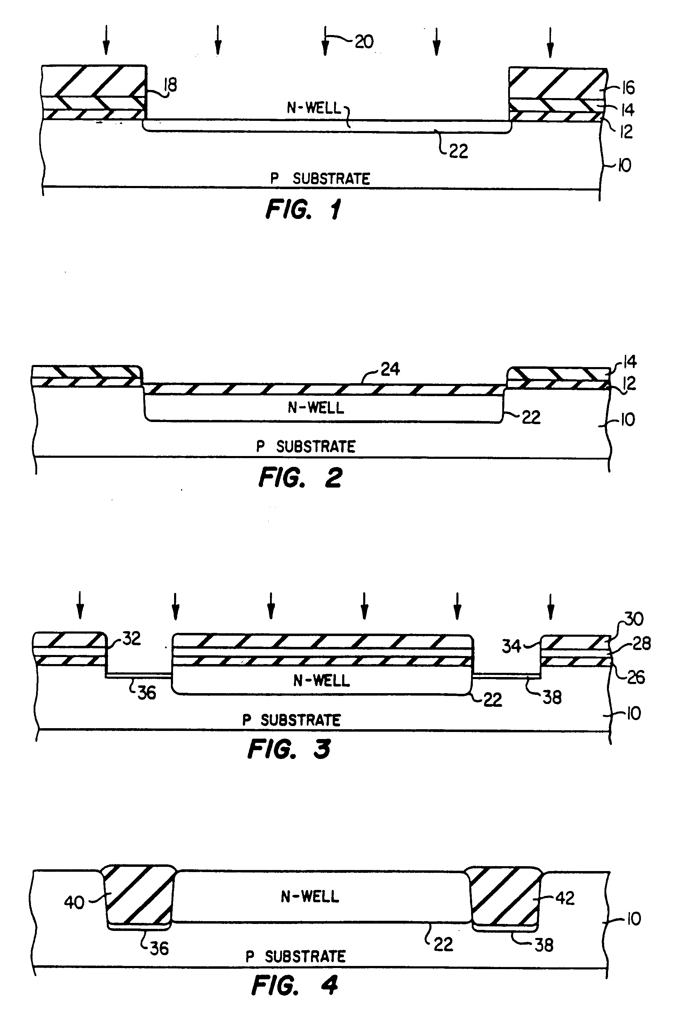

Turning now to the drawings, and particularly to FIGURE 1, the fabrication of a bipolar transistor according to the invention is commenced by selecting a semiconductor substrate 10 having electrical characteristics suitable for fabricating both bipolar and CMOS transistors. A silicon substrate material of a P-type conductivity, a <100> crystal orientation, and a conductivity of about 10 ohm-centimeter is preferable. A local thin thermal silicon oxide 12 is grown over the surface of the substrate 10. A thin silicon nitride layer 14 is deposited on the wafer, such as by a low pressure chemical vapor deposition (LPCVD) process. Covering the silicon nitride 14 is a layer of photoresist material 16 which is spun over the surface of the wafer, and patterned to define an opening 18 for locating an N-well. Similar openings would be defined in the photoresist 16 for forming N-wells associated with PMOS transistors. A portion of the silicon nitride layer 14 and silicon oxide layer 12 are removed by conventional etching processes in the area defined by the mask opening 18.

An ion implant 20 is next conducted, using an N-type impurity, for forming an N-well 22 in the mask openings of the substrate 10. The implant is conducted at an energy level sufficient to form a shallow N-well 22. Phosphorus may be used as the N-type impurity implant at a dosage of about 5E12 atoms/cm2. Other N-type impurities and dosages may be used with satisfactory results.

As shown in FIGURE 2, the wafer is subjected to a silicon oxidizing environment in which a thin silicon oxide layer 24 is grown over the N-well area 22. The photoresist mask 16 is shown removed, and the N-well 22 has been diffused downwardly, due to the temperature used in growing the N-well oxide 24. The thin silicon oxide and nitride layers 12 and 14 are then removed.

As illustrated in FIGURE 3, a new layer of silicon oxide 26 is grown over the surface of the substrate 10, and comprises a buffer oxide. An oxidation mask comprising a deposited silicon nitride layer 28 is formed over the oxide layer 26. A layer of photoresist material 30 is spread over the surface of the wafer and patterned to define openings 32 and 34 circumscribing the N-well 22. The silicon nitride 28 and oxide 26 are removed in the area defined by the openings using conventional etching techniques. A portion of the silicon substrate 10 is also etched to form a recess in the area defined by the mask opening 32 and 34. The mask openings 32 and 34 define areas in which a thick field oxide will be formed, and thus the substrate material 10 is etched downwardly to the extent desired for forming sufficiently thick field oxide recessed from the surface of the substrate 10.

The wafer is ion implanted with boron to form P-type channel stop areas 36 and 38. The wafer is subjected to a high temperature steam ambient for growing a thick field oxide in the unmasked areas of the substrate 10. Particularly, the silicon substrate material located under the openings 32 and 34 is consumed until a thick field oxide has been grown. The thick field oxide 40 and 42 is depicted in FIGURE 4, after the silicon oxide layer 26, the nitride layer 28 and the photoresist mask 30 have been removed.

The foregoing illustrates one method of forming N-wells suitable for use in connection with bipolar transistors and MOSFET transistors. As an alternative, heavily doped N-type buried layers can be formed within the substrate 10, with an N-type epitaxial layer of semiconductor material deposited thereover. Thick field oxide regions can be formed in the epitaxial layer, similar to that described above, for providing lateral isolation between circuits. Moreover, P-wells can be formed in other areas of the wafer for use in connection with NMOS transistors.

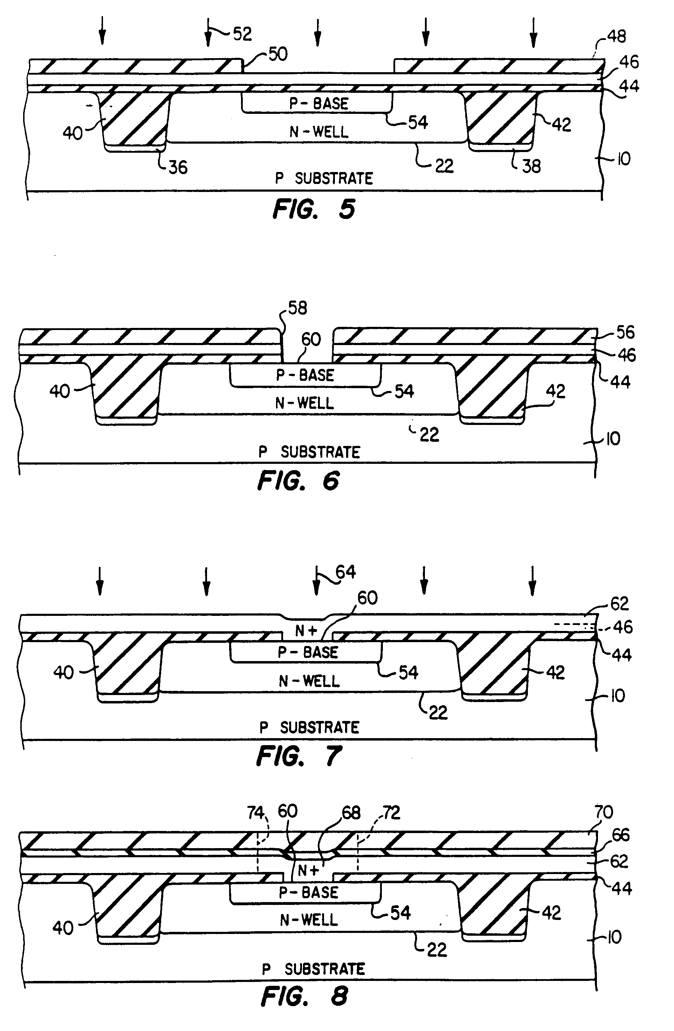

With reference now to FIGURE 5, a thin high quality gate oxide 44 is grown on the surface of the silicon wafer. A high quality gate oxide can be formed by first growing a thin sacrificial oxide layer, oxidizing it together with any silicon nitride deposits, and then removing the oxides. This pregate or sacrificial oxide, eliminates the Kooi white-ribbon effect which is characteristic of silicon nitride deposits formed in undesired areas of the wafer. In any event, the high quality gate oxide 44 is grown on the silicon wafer after the removal of the pregate oxides and nitrides have been removed. The gate oxide 44 is formed to a depth desired for separating the gate conductors from the transfer channels of the MOSFET transistors. Deposited over the gate oxide 44 is a layer of polysilicon 46. The polysilicon layer 46 is thin, being about 1,000 angstroms thick. A photoresist mask 48 is spun over the surface of the wafer, and patterned to define an opening 50 for forming a semiconductor intrinsic base region in the N-well 22. Preferably, the masked opening 50 is formed intermediate the thick field oxide regions 40 and 42. The polysilicon 46 functions primarily as a passivation layer for protecting contamination from entering the gate oxide layer 44. However, the polysilicon 46 should be thin enough to allow ion implantation therethrough.

A boron implant 52 is conducted at a dosage of about IE14 atoms/cm2. The implant 52 is conducted in a manner to place the impurity near the surface of the N-well 22. The dosage can be adjusted for the desired transistor gain (h_{fe}) and breakdown voltage of the bipolar transistor. Higher breakdown voltages may require deeper base implant regions 54, and laterally wider areas to reduce the corresponding electric fields attendant with higher voltages applied to bipolar devices used in high voltage and analog applications. On the other hand, for high performance and high speed bipolar devices, the base region 54 should be thin and the implant dosage should be at a minimum.

The photoresist 48 is then removed, and a new layer 56 is spread on the wafer and patterned to define an opening 58 for locating the emitter region in the semiconductor base region 54. Because the emitter is centered within the base region 54, the former becomes "nested" with respect to the intrinsic base 54. As noted in Figure 6, the gate oxide 44 and the thin polysilicon 46 are etched, thereby exposing a portion of the face of the intrinsic base region 54. The window 60 which defines the exposed portion of the intrinsic base region 54 also defines the effective emitter area which will subsequently form a junction in the base region 54. The window 60 may be subjected to a deglazing process, wherein a clean surface on the intrinsic base region 54 is obtained.

With regard to FIGURE 7 of the drawings, a much thicker layer of polysilicon 62 is deposited over the surface of the wafer. The polysilicon layer 62 merges with that of the first layer 46 and forms a homogeneous layer of polysilicon, preferably of about 4,000 angstroms thick. As noted in FIGURE 7, the polysilicon 62 makes contact in the window 60 with the underlying semiconductor intrinsic base region 54. The composite polysilicon layer 62 is implanted 64 with an N-type impurity, such as arsenic or phosphorus, and at a dosage to achieve a heavily doped structure.

In the event the bipolar transistor of the invention is constructed without regard to the simultaneous fabrication of corresponding MOSFET devices, the two layers of polysilicon 46 and 62 need not be deposited separately, rather a single thick layer can be deposited in the step shown in FIGURE 7. In other words, without the need for MOSFET gate structures, the integrity of the gate oxide is not as critical, and thus the passivation function of the first thin polysilicon layer 46 is thus not required.

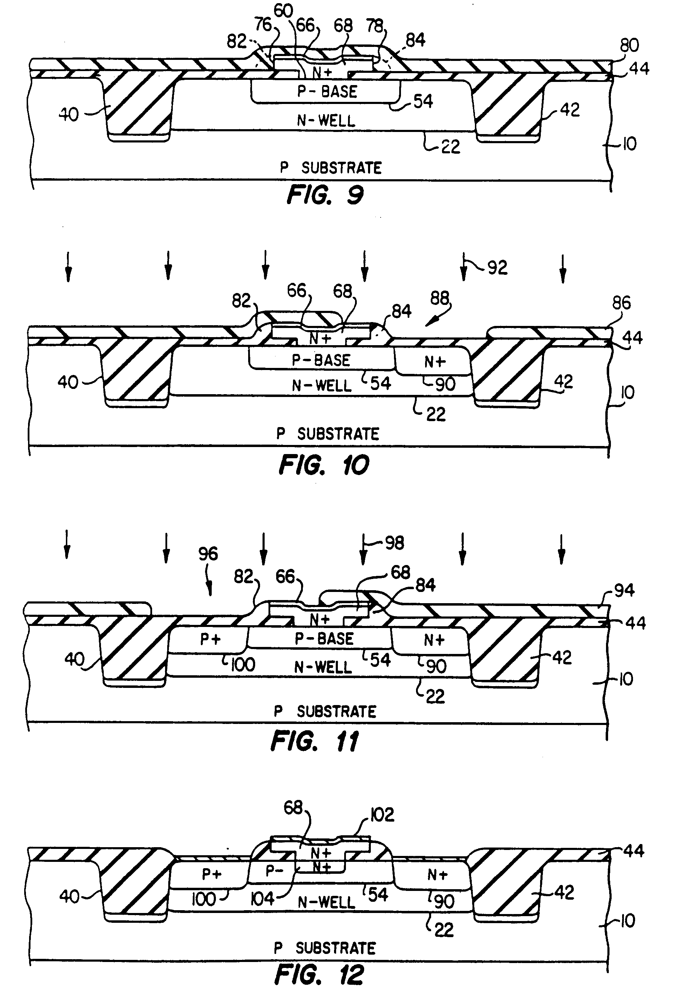

With reference now to FIGURE 8, a photoresist material 70 is spread over the wafer and patterned to define the polyemitter 68. The photoresist material 70 is removed in the areas lying outside the dotted lines 72 and 74. The periphery of the gate structures of the PMOS and NMOS devices are similarly defined. The polysilicon 62 is also removed in the areas lying outside the dotted lines 72 and 74 by a conventional etching process. The polyemitter 68 and the MOSFET transistor gate structures (not shown) are thus defined.

FIGURE 9 illustrates the polyemitter 68 located with respect to the P-type base region 54. Importantly, the polyemitter 68 contacts the intrinsic base region 54 at the window area 60 formed in the gate oxide 44. Equally as important, the periphery of the base region 54 extends outwardly beyond the sidewall 76 and 78 of the polyemitter 68. This is important so that a subsequently formed extrinsic base region and collector region can be formed contiguous with the intrinsic base region 54, and self aligned with respect to the polyemitter 68. To that end, the P-type intrinsic base region 54 can extend further laterally than shown, and even across the entire face of the N-well 22.

After the polyemitter 68 has been defined, together with the MOSFET transistor gate conductors, a thick layer of silicon oxide 80 is deposited over the surface of the wafer. The oxide 80 can be deposited using LPCVD techniques to form a conformal layer of insulating silicon oxide, as noted in FIGURE 9. The deposited silicon oxide 80 is anisotropically etched in the downward direction, such as by a reactive ion etching process. The etch process is allowed to proceed until a layer of silicon oxide has been removed in a downward direction to a depth substantially equal to the thickness of such oxide layer 80. Because of the anisotropic removal of the silicon oxide 80, all that remains is that which is shown by the broken lines and identified by reference characters 82 and 84. The anisotropic nature of the etch process is not effective in removing all the silicon oxide on the sidewalls of the polyemitter 68, as the silicon oxide is much thicker in this area, as measured vertically, than in other areas, such as that overlying the polyemitter 68 or the field oxide areas 40 and 42.

An optional layer of silicon nitride (not shown) can be deposited over the polyemitter 68 to function both as a sacrificial layer during the anisotropic etch, and as a blocking layer to prevent the passage therethrough of ions during subsequent ion implants. The optional nitride layer would be deposited on the polysilicon 62 and patterned prior to the depositing of the photoresist 70.

The polysilicon gate conductors of the MOSFET transistors formed during the fabrication of the exemplary bipolar transistor would also include similar accumulations of insulating silicon oxide on the sidewalls thereof. As noted above, the sidewall oxide on the NMOS transistor gate conductor facilitates the fabrication of lightly doped drain areas, which are important to the operation of small area NMOS devices.

FIGURE 10 illustrates the polyemitter 68 peripherally bounded with the sidewall oxide 82 and 84. The wafer is also shown with a layer of photoresist 86, patterned to form an opening 88 defining a collector region location in the N-well 22. The thin oxide 44 overlying the collector region can be optionally thinned or removed before the implant. An ion implant 89 is conducted over the wafer, using phosphorus or arsenic to form an N+ collector region 90 in the N-well 22. The N+ collector region 90 is contiguous with the base region 54. That portion of the intrinsic base region 54 which extended laterally beyond the outer edge of the sidewall oxide 84 is compensated, or counterdoped, by the opposite implant impurity, such that it becomes a part of the N+ collector region 90. Alternately, by precise pattern aligning, the intrinsic base region could have been terminated before extending into the collector region. This would result in lower parasitic capacitances, and would increase breakdown voltage capability.

As noted in FIGURE 10, the collector region 90 is self aligned with respect to the polyemitter sidewall oxide 84, and contiguous with the intrinsic base region 54. Moreover, the mask alignment of the photoresist layer 86 is not critical, except insofar as the peripheral edge of the opening 88 should generally overlay the thick field oxide 42 and the polyemitter 68. Depending on the patterning of the photoresist 86 to locate the edge thereof covering the polyemitter 68, the N-type implant impurity may enter the polyemitter 68. This is inconsequential, as the implant impurity and that of the polyemitter 68 are the same. At the same time the N+ collector region 90 is formed, corresponding source and drain regions may be formed in the NMOS transistors.

Referring now to FIGURE 11, the photoresist mask 86 is removed, and an additional layer of photoresist material 92 is spread over the surface of the wafer. The photoresist 92 is patterned to define an opening 96 for locating an extrinsic base region within the N-well 22. The alignment of the photoresist mask 92 in forming an extrinsic base region is somewhat more critical than the mask used in forming the collector region. The ion implant 98 may drive some P+ ions into the N+ polyemitter 68. However, in the nested type of polyemitter, a portion of the oxide 44 separates the polysilicon emitter from the intrinsic base region 54 and thus the P-type impurities are driven into a noncritical location of the polyemitter 68. The optional nitride layer referred to above would prevent the P-type implant 89 from affecting the N-type polyemitter 68.

The extrinsic base region is provided primarily for forming an electrical connection to the intrinsic base region 54. The active transistor action of the bipolar transistor occurs in the intrinsic base region 54, as such semiconductor region is between the collector 90 (and N-well 22) and an emitter region to be subsequently formed.

A P-type impurity, such as boron, is implanted 98 into the opened areas of the wafer, thereby forming a P+ extrinsic base region 100 in the bipolar transistor. In a similar manner, source and drain openings can be formed in the photoresist mask 92 in the PMOS transistor area, and implanted at the same time as the bipolar transistor. The photoresist layer 92 is then removed.

As noted in FIGURE 11, the extrinsic base region 100 is self aligned with respect to the polyemitter sidewall oxide 82. Significantly, both semiconductor regions 90 and 100 are self aligned with respect to the polyemitter 68, including the sidewall oxide 82 and 84. With the noted polyemitter structure, there can be some variance in the location of the emitter opening in the thin gate oxide 44 without causing concern that the emitter region, which is centered at the oxide opening, will encroach into either the extrinsic base 100 or the collector 90. The distance between the oxide opening edge and the collector region 90 is related to the emitter-collector breakdown voltage and the gain of the bipolar transistor. In both the nested and walled emitter type of structures, the sidewall oxide 84 assures that when the regions are implanted or otherwise formed, a minimum distance will exist between the emitter region and the collector region. Of course, lateral diffusion of the emitter and collector regions can have an effect on the spacing there between.

The bipolar transistor collector region 90 and the extrinsic base region 100 are patterned (not shown), and the gate oxide 44 located thereover is removed. In like manner, the gate oxide on the source and drain regions of the MOSFET transistors is also removed. The surface of the wafer is then covered with a layer 102 of titanium and patterned, as indicated in FIGURE 12. In certain situations where only bipolar transistors are to be formed, a layer of platinum can be used. In FIGURE 12, the collector region 90 and extrinsic base region 100 are shown covered with the titanium metal. The polyemitter 68 is also shown covered with a conductive coating of titanium 102.

In accordance with conventional silicon processing techniques, the wafer is then heated to form titanium silicide over the regions previously covered with titanium. It may be preferable to react the titanium in a nitrogen ambient for also forming a conductive titanium nitride. The excess titanium existing after the reaction with the silicon to form the silicide is then removed. The titanium metal layer 102 is etched so that only the electrical contact surfaces of the bipolar and MOSFET transistors are covered with such metal. The elevated temperature of the wafer is also effective in diffusing the N+ impurity in the polyemitter 68 down into the intrinsic base region 54, thereby forming an N+ emitter region 104 in the bipolar transistor. In the event platinum is used in place of titanium, the anneal treatment can be performed before deposition of platinum The formation of the emitter in this manner forms a buried emitter contact between the polyemitter 68 and the semiconductor emitter region 104. External electrical contact is not made directly to the emitter region 104, but rather through the conductive polyemitter 68.

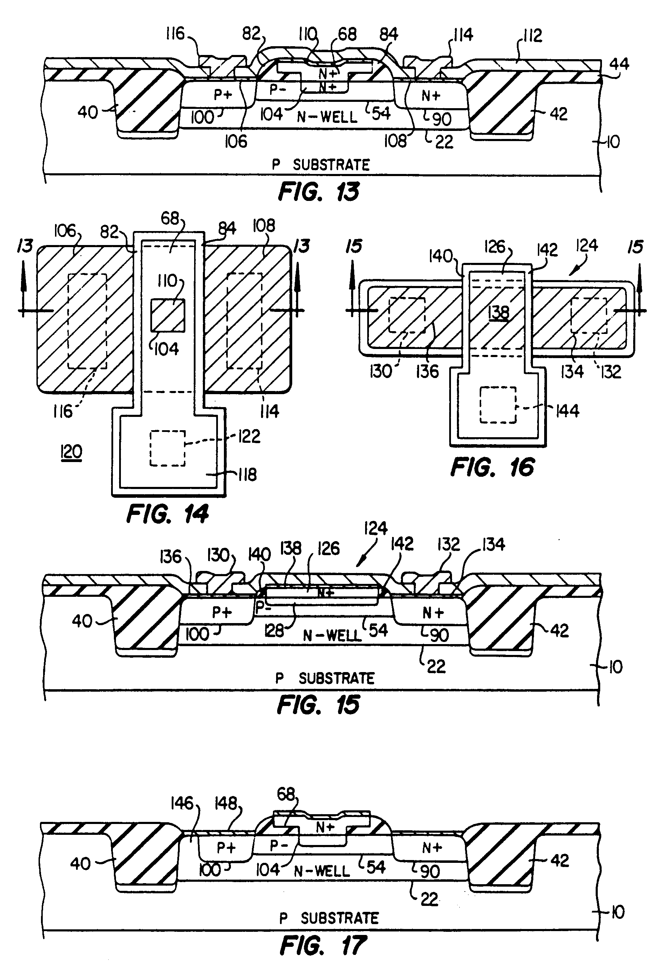

FIGURE 13 depicts the wafer in substantially completed form, with the titanium silicide 106 and 108 covering the respective extrinsic base region 100 and the collector region 90. A titanium silicide layer 110 also covers the top of the polyemitter 68 for providing a good electrical contact thereto. A layer of insulation 112 is then deposited over the surface of the wafer and patterned to form openings to the silicide interfaces of the collector region 90 and the extrinsic base region 100. While not shown in FIGURE 13, an opening is also formed in the insulation 12 to the polyemitter 68 at an off-site location. A layer of metal is deposited over the wafer and patterned to form a collector conductor 114, a base conductor 116 and an emitter conductor.

A top view of the wafer structure of FIGURE 13 is shown in FIGURE 14. The polyemitter 68 is shown with an off-site extension pad 118 formed over a field oxide region 120 of the wafer. An electrical contact 122 is formed in contact with the polyemitter extension pad 118. As a result, the emitter contact 122 is also in electrical contact through the polyemitter 68 with the buried emitter 104. As can be seen from FIGURE 14, the emitter 104 is nested within the base region 54, in a position defined by the contact area of the polyemitter 68 with respect to the base region 54.

The foregoing illustrates the fabrication and resulting structure of an NPN bipolar transistor. Those skilled in the art can utilize the description herein for fabricating a PNP bipolar transistor. Various semiconductor impurity regions will need to be changed, and perhaps the impurity concentrations, to achieve a PNP transistor with suitable operating characteristics. Also, when fabricating MOSFET transistors with PNP bipolar transistors, the gate conductor doping impurities may require changing.

FIGURES 15 and 16 illustrate respectively cross-sectional and top views of a walled emitter bipolar transistor 124. A bipolar transistor constructed according to this embodiment does not have an emitter opening in the base region 54 nested under and recessed from the edges of the polyemitter 68. Rather, the polyemitter 126 has a width substantially equal to the corresponding width of the emitter region 128, and is in full contact therewith. When the N-type impurities are diffused from the polyemitter 126 into the intrinsic base region 54, a large area emitter 128 is thereby formed. Even though the same self-aligning features exist with respect to the formation of the transistor 124, as compared with that previously described, bipolar transistor 124 can be made using a smaller wafer area. Because the buried emitter 128 need not be nested with respect to the polyemitter 126, a transistor using less wafer area can be formed. As with the embodiment shown in FIGURE 14, the transistor 124 of FIGURE 16 includes an off-site emitter contact 144.

In FIGURE 17, a bipolar transistor structure similar to that of FIGURE 13 is illustrated, but further includes a Schottky-clamped base-collector junction. To that end, a portion 146 of the N-well 22 is formed at the face of the wafer, adjacent the extrinsic base region 100. A conductive silicide 148 overlies both the N-well surface portion 146 and the extrinsic base 148, thereby forming a metal barrier contact therebetween. As a result, the base-collector junction of the bipolar transistor has formed in parallel thereto a Schottky diode, and thus the transistor is prevented from becoming saturated when driven into a conductive state.

From the foregoing, the fabrication steps and resulting structure of a bipolar transistor have been disclosed. A technical advantage of the bipolar transistor fabrication of the invention is that it can be constructed using steps compatible with the formation of MOSFET transistors. Therefore, an attendant technical advantage of the invention is that MOSFET transistors and bipolor transistors of the invention can be fabricated jointly on a wafer and thereby simplify the integration of bipolar and MOSFET transistors.

Another technical advantage of the invention presented is that by using MOSFET fabrications techniques, a self aligned bipolar transistor can be constructed using very little wafer area. As a result, the electrical operation of the bipolar transistor is enhanced, insofar as there is less parasitic capacitance, and the resultant high frequency operation thereof is extended.

Yet another technical advantage of the invention enables the construction of nested and walled polyemitter bipolar transistors. The fabrication steps are simplified in that the extrinsic base and collector regions thereof are formed on opposing sides of the polyemitter and self aligned with respect to the edges of the polyemitter. Sidewall oxide formed on the polyemitter presents the technical advantage of spacing the corresponding collector and extrinsic base regions from the emitter, thereby assuring that junction punchthrough is avoided.

Still another technical advantage of the invention exists in that a Schottky-clamped bipolar transistor is easily fabricated, using MOSFET transistor compatible fabrication steps.

## Claims

1. A method of fabricating a bipolar transistor, comprising the steps of
forming a semiconductor well (22) of a first conductivity type at the face of a silicon semiconductor body (10);
forming a semiconductor base region (54) of a second conductivity type in the surface of said semiconductor well (22);
forming a polycrystalline silicon emitter structure (68) of said first conductivity type in contact with said semiconductor base region (54), said emitter structure (68) having sidewalls (76,78), and being provided with an impurity of said first conductivity type;
forming insulation (82,84) on said sidewalls (76,78) of said polycrystalline silicon emitter structure (68);
forming a semiconductor collector region (90) of a first conductivity type in a first region of said well (22) and self-aligned with respect to said insulation (84) for said emitter structure (68);
forming a semiconductor extrinsic base region (100) of said second conductivity type in a second region of said well (22) and self-aligned with respect to said insulation (82) for said emitter structure (68), said extrinsic base region (100) being contiguous with said semiconductor base region (54); and
diffusing an impurity of said first conductivity type from said polycrystalline silicon emitter structure (68) into said base region (54) so as to form therein a semiconductor emitter region (104) of said first conductivity type.

2. The method of claim 1 further including forming a temporary blocking layer material covering said emitter structure (68) to prevent undesired impurities of an opposite conductivity type from entering said emitter structure (68).

3. The method of claim 1 further including forming an insulation layer (44) between said emitter structure (68) and said semiconductor base region (54), forming an opening in said insulation layer (44) and forming said emitter structure (68) through said opening in contact with said semiconductor base region.

4. The method of claim 1 further including forming said base region (54) sand said collector region (90) at the face of said semiconductor body (10) and forming a conductive silicide (106,108,110) covering said base region (100), said collector region (90) and a portion of said polycrystalline silicon emitter structure (68) to provide electrical contact surfaces.

5. The method of claim 4 further including forming a portion (146) of said semiconductor well (22) at the face of said semiconductor body (10) adjacent to said extrinsic base region (100) and forming a metallic covering (148) covering a portion of both said semiconductor well (146) and said extrinsic base region (100) to thereby form a barrier diode in parallel with a base collector junction of said bipolar transistor.

6. The method of claim 3 further including forming a MOSFET device gate insulator with the insulation of said insulation layer (44), and forming a gate conductor with the material of said emitter structure (68).

7. The method of claim 6 further including forming said gate insulator at the same time as said emitter insulation layer (44) is formed, and forming said gate conductor at the same time as said emitter structure (68) is formed.

8. The method of claim 6 further including forming a sidewall insulation (82,84) on said emitter structure (68) at the same time and by the same steps as the corresponding sidewall insulation is formed on said gate conductor.

9. The method of claim 6 further including forming a source and drain region of a first type of MOSFET device when said extrinsic base region (100) is formed, and forming source and drain regions of a second type of MOSFET device when said collector region (90) is formed.

10. A silicon bipolar transistor, comprising:
a semiconductor well (22) of the first conductivity type;
a conductive polycrystalline silicon strip (62) overlying said well (22) and extending substantially from one side thereof to the other, one side of said polycrystalline silicon strip (62) extending laterally beyond said semiconductor well (22);
a semiconductor intrinsic base region (54) of a second conductivity type underlying said polycrystalline silicon strip (62);
a semiconductor emitter region (68) in contact with said polycrystalline silicon emitter strip (62) and formed in said intrinsic base region (54);
an extrinsic base region (100) and a collector region (90) formed on opposing sides of said polycrystalline silicon emitter strip (62), said extrinsic base region (100) and said collector region (90) being formed in electrical contact with said intrinsic base region (54);
and
an insulation layer (44) between said polycrystalline silicon emitter strip (68) and said intrinsic base region (54) and an opening in said insulation layer (44) through which said polycrystalline silicon emitter strip (68) is formed in contact with said base region (54).

11. The bipolar transistor of claim 10 further including respective electrodes (116,114) formed in contact with said extrinsic base region (100), with said collector region (90), and with the part of said polycrystalline silicon emitter strip (68) extending laterally beyond said semiconductor well (22).

12. The bipolar transistor of claim 10 further including a nested buried emitter (68) comprising an emitter region (104) formed in said intrinsic base region (54) and having a width narrower than the corresponding width of said polycrystalline silicon emitter strip.

13. The bipolar transistor of claim 10 further including a walled emitter (128) comprising said polycrystalline silicon emitter strip (126) in contact with said base region (54), said walled emitter (128) having a width substantially equal to the corresponding width of said polycrystalline silicon emitter strip (126).

14. The bipolar transistor of claim 10 further including sidewall insulation (82,84) on said polycrystalline silicon emitter strip (68), and wherein said extrinsic base region (100) and said collector regions (90) are self-aligned with respect to said sidewall insulation (82,84).

15. A silicon lateral bipolar transistor having regions of alternate conductivity, comprising:
an impurity well (22) of a first conductivity type;
a semiconductor base region (54) of a second conductivity type formed in said impurity well (22) of said first conductivity type;
a semiconductor emitter region (104) of said first conductivity type formed within said base region (54);
a polycrystalline silicon conductor (68) in electrical contact with said emitter region (104);
silicon oxide (82,84) formed on sidewalls (76,78) of said polycrystalline silicon conductor (68);
a semiconductor collector region (90) of said first conductivity type formed in said impurity well (22) and self-aligned with said sidewall insulation (82,84); and
an extrinsic base region (100) of said conductivity type formed in said impurity well (22) and self-aligned with said sidewall insulation (82);
wherein said collector region (90) and said extrinsic base region (100) are formed on opposing sides of said polycrystalline silicon conductor (68).

16. The lateral bipolar transistor of claim 15 further including a buried contact (68) formed where said emitter region (104) is in electrical contact with said polycrystalline silicon conductor (68), and further including a contact (122) laterally offset from said buried contact (68) for effecting external electrical contact to said polycrystalline silicon conductor (68).

17. The lateral bipolar transistor of claim 16 wherein said buried contact (68) is of a width smaller than the corresponding width of that part of said polycrystalline silicon conductor overlying said buried contact (68).

18. The lateral bipolar transistor of claim 16 wherein said polycrystalline silicon conductor (118) is elongate and extends beyond said impurity well (22) and said offset contact (122) is disposed proximate an end of said polycrystalline silicon conductor (118).

19. A method of forming self-aligned semiconductor regions in a bipolar transistor, comprising:
forming a semiconductor base region (54) in the face of a silicon substrate (10);
forming an insulator layer (44) having an opening on the semiconductor base region (54);
forming a doped polycrystalline silicon layer (68) overlying said insulator layer (44) and in contact with said base region (54) through said opening to define an emitter region (104), said polycrystalline silicon layer (68) having an edge (118) extending laterally beyond said emitter region (104);
forming a second insulator layer (84) on said edge of said polycrystalline silicon layer (68);
forming a collector region (90) in the face of said substrate (10) aligned with said second insulator layer (84); and
diffusing the dopant of said polycrystalline silicon layer (68) into said base region (54) to form said emitter region (104).

20. The method of claim 19 further including forming a further insulator layer (82) on a second edge (76) of said polycrystalline silicon layer (68) and forming an extrinsic base region (100) in said substrate (10) aligned with said further insulator layer (82) and contiguous with said base region (54).

## Patentansprüche

1. Verfahren zur Herstellung eines bipolaren Transistors, das die folgenden Schritte aufweist:
Bilden einer Halbleitersenke (22) von einem ersten Leitfähigkeitstyp an der Seite eines Silizium-Halbleiterkörpers (10),
Bilden einer Halbleiter-Basiszone (54) von einem zweiten Leitfähigkeitstyp in der Oberfläche der Halbleitersenke (22),
Bilden einer polykristallinen Silizium-Emitterstruktur (68) vom ersten Leitfähigkeitstyp, die mit der Halbleiter-Basiszone (54) in Kontakt ist, wobei die Emitterstruktur (68) Seitenwände (76, 78) aufweist, und mit einem Störstoff vom ersten Leitfähigkeitstyp versehen wird,
Bilden einer Isolierung (82, 84) auf den Seitenwänden (76, 78) der polykristallinen Silizium-Emitterstruktur (68),
Bilden einer Halbleiter-Kollektorzone (90) von einem ersten Leitfähigkeitstyp in einem ersten Bereich der Senke (22) in Selbstausrichtung bezüglich der Isolierung (84) für die Emitterstruktur (68),
Bilden einer störstellenleitenden Halbleiter-Basiszone (100) vom zweiten Leitfähigkeitstyp in einem zweiten Bereich der Senke (22) in Selbstausrichtung bezüglich der Isolierung (82) für die Emitterstruktur (68), wobei die äußere Basiszone (100) an die Halbleiter-Basiszone (54) angrenzt, und
Eindiffundieren eines Störstoffs vom ersten Leitfähigkeitstyp von der polykristallinen Silizium-Emitterstruktur (68) in die Basiszone (54), um darin eine Halbleiter-Emitterzone (104) vom ersten Leitfähigkeitstyp zu bilden.

2. Verfahren nach Anspruch 1, bei dem überdies ein vorübergehend vorgesehenes Sperrschichtmaterial gebildet wird, das die Emitterstruktur (68) bedeckt, um zu verhindern, daß unerwünschte Störstoffe von einem entgegengesetzten Leitfähigkeitstyp in die Emitterstruktur (68) eindringen.

3. Verfahren nach Anspruch 1, bei dem überdies eine Isolierschicht (44) zwischen der Emitterstruktur (68) und der Halbleiter-Basiszone (54) gebildet wird, eine Öffnung in der Isolierschicht (44) gebildet wird und die Emitterstruktur (68) durch die Öffnung hindurch in Kontakt mit der Halbleiter-Basiszone gebildet wird.

4. Verfahren nach Anspruch 1, bei dem überdies die Basiszone (54) und die Kollektorzone (90) an der Seite des Halbleiterkörpers (10) gebildet werden und ein leitendes Silicid (106, 108, 110) gebildet wird, das die Basiszone (100), die Kollektorzone (90) und einen Teil der polykristallinen Silizium-Emitterstruktur (68) bedeckt, um elektrische Kontaktoberflächen zu schaffen.

5. Verfahren nach Anspruch 4, bei dem überdies ein Teil (146) der Halbleitersenke (22) an der Seite des Halbleiterkörpers (10) angrenzend an die störstellenleitende Basiszone (100) gebildet wird und ein Metallüberzug (148) gebildet wird, der einen Teil sowohl der Halbleitersenke (146) als auch der störstellenleitenden Basiszone (100) bedeckt, um dadurch eine Sperrschichtdiode zu bilden, die parallel zu einem Basis-Kollektor-Anschluß des bipolaren Transistors ist.

6. Verfahren nach Anspruch 3, bei dem überdies ein Gate-Isolator einer MOSFET-Anordnung aus der Isolation der Isolierschicht (44) gebildet wird und ein Gate-Leiter aus dem Material der Emitterstruktur (68) gebildet wird.

7. Verfahren nach Anspruch 6, bei dem überdies der Gate-Isolator gleichzeitig mit der Emitterisolationsschicht (44) gebildet wird und der Gate-Leiter gleichzeitig mit der Emitterstruktur (68) gebildet wird.

8. Verfahren nach Anspruch 8, bei dem überdies eine Seitenwandisolierung (82, 84) auf der Emitterstruktur (68) zur gleichen Zeit und durch dieselben Schritte gebildet wird, wie die entsprechende Seitenwandisolierung auf dem Gate-Leiter.

9. Verfahren nach Anspruch 6, bei dem überdies eine Source-Zone und Drain-Zone einer ersten Art von MOSFET-Anordnung gebildet werden, wenn die störstellenleitende Basiszone (100) gebildet wird, und Source- und Drain-Zonen einer zweiten Art von MOSFET-Anordnung gebildet werden, wenn die Kollektorzone (90) gebildet wird.

10. Bipolarer Silizium-Transistor mit
einer Halbleitersenke (22) vom ersten Leitfähigkeitstyp,
einem leitenden, polykristallinen Siliziumstreifen (62), der über der Senke (22) liegt und sich im wesentlichen von einer Seite hiervon zu der anderen erstreckt, wobei sich eine Seite des polykristallinen Siliziumstreifens (62) seitlich jenseits der Halbleitersenke (22) erstreckt,
einer eigenleitenden Halbleiter-Basiszone (54) von einem zweiten Leitfähigkeitstyp, die unter dem polykristallinen Siliziumstreifen (62) liegt,
einer Halbleiter-Emitterzone (68), die mit dem polykristallinen Silizium-Emitterstreifen (62) in Kontakt steht und in der eigenleitenden Basiszone (54) gebildet ist,
einer störstellenleitenden Basiszone (100) und einer Kollektorzone (90), die auf entgegengesetzten Seiten des polykristallinen Silizium-Emitterstreifens (62) gebildet sind, wobei die störstellenleitende Basiszone (100) und die Kollektorzone (90) so gebildet sind, daß sie mit der eigenleitenden Basiszone (54) in elektrischem Kontakt stehen, und
einer Isolierschicht (44) zwischen dem polykristallinen Silizium-Emitterstreifen (68) und der eigenleitenden Basiszone (54) und einer Öffnung in der Isolierschicht (44), durch die der polykristalline Silizium-Emitterstreifen (68) in Kontakt mit der Basiszone (54) gebildet ist.

11. Bipolarer Transistor nach Anspruch 10, der überdies Elektroden (116, 114) aufweist, die so gebildet sind, daß sie mit der störstellenleiltenden Basiszone (100), der Kollektorzone (90) bzw. dem Teil des polykristallinen Silizium-Emitterstreifens (68) in Kontakt stehen, der sich seitlich jenseits der Halbleitersenke erstreckt.

12. Bipolarer Transistor nach Anspruch 10, der überdies einen nestartig nach innen verlegten Emitter (68) mit einer Emitterzone (104) aufweist, die in der eigenleitenden Basiszone (54) gebildet ist und eine Breite besitzt, die geringer als die entsprechende Breite des polykristallinen Silizium-Emitterstreifens ist.

13. Bipolarer Transistor nach Anspruch 10, der überdies einen mit Wänden versehenen Emitter (128) enthält, der den polykristallinen Silizium-Emitterstreifen (126) aufweist, der mit der Basiszone (54) in Kontakt ist, wobei der mit Wänden versehene Emitter (128) eine Breite besitzt, die im wesentlichen gleich der entsprechenden Breite des polykristallinen Silizium-Emitterstreifens (126) ist.

14. Bipolarer Transistor nach Anspruch 10, der überdies eine Seitenwandisolierung (82, 84) auf dem polykristallinen Silizium-Emitterstreifen (68) enthält, und bei dem die störstellenleitende Basiszone (100) und die Kollektorzonen (90) bezüglich der Seitenwandisolierung (82, 84) selbstausgerichtet sind.

15. Bipolarer Silizium-Lateraltransistor mit Zonen abwechselnder Leitfähigkeit, mit
einer Störstoffsenke (22) von einem ersten Leitfähigkeitstyp,
einer Halbleiter-Basiszone (54) von einem zweiten Leitfähigkeitstyp, die in der Störstoffsenke (22) vom ersten Leitfähigkeitstyp gebildet ist,
einer Halbleiter-Emitterzone (104) vom ersten Leitfähigkeitstyp, die in der Basiszone (54) gebildet ist,
einem polykristallinen Siliziumleiter (68) in elektrischem Kontakt mit der Emitterzone (104),
einem auf Seitenwänden (76, 78) des polykristallinen Siliziumleiters (68) gebildeten Siliziumoxid (82, 84),
einer Halbleiter-Kollektorzone (90) vom ersten Leitfähigkeitstyp, die in der Störstoffsenke (22) gebildet und mit der Seitenwandisolierung (82, 84) selbstausgerichtet ist und
einer störstellenleitenden Basiszone (100) von dem genannten Leitfähigkeitstyp, die in dem Störstoffensenke (22) gebildet und mit der Seitenwandisolierung (82) selbstausgerichtet ist,
wobei die Kollektorzone (90) und die störstellenleitende Basiszone (100) auf entgegengesetzten Seiten des polykristallinen Siliziumleiters (68) gebildet sind.

16. Bipolarer Lateraltransistor nach Anspruch 15, der überdies einen nach innen verlegten Kontakt (68) aufweist, der dort gebildet ist, wo die Emitterzone (104) in elektrischem Kontakt mit dem polykristallinen Siliziumleiter (68) steht, und der überdies einen Kontakt (122) besitzt, der seitlich gegenüber dem nach innen verlegten Kontakt (68) versetzt ist, um einen äußeren elektrischen Kontakt mit dem polykristallinen Siliziumleiter (68) zu bewirken.

17. Bipolarer Lateraltransistor nach Anspruch 16, bei dem der nach innen verlegte Kontakt (68) eine Breite besitzt, die geringer ist als die entsprechende Breite jenes Teils des polykristallinen Siliziumleiters, der über dem nach innen verlegten Kontakt (68) liegt.

18. Bipolarer Lateraltransistor nach Anspruch 16, bei dem der polykristalline Siliziumleiter (118) länglich ausgebildet ist und sich über die Störstellensenke (22) hinaus erstreckt, und bei dem der versetzte Kontakt (122) in der Nähe eines Endes des polykristallinen Siliziumleiters (118) angeordnet ist.

19. Verfahren zur Bildung selbstausgerichteter Halbleiterzonen in einem bipolaren Transistor, bei dem folgendes vorgesehen ist:
Bilden einer Halbleiter-Basiszone (54) in der Seite eines Siliziumsubstrats (10),
Bilden einer Isolierschicht (44) mit einer Öffnung auf der Halbleiter-Basiszone (54),
Bilden einer dotierten polykristallinen Siliziumschicht (68), die über der Isolierschicht (44) liegt und mit der Basiszone (54) durch die Öffnung zur Festlegung einer Emitterzone (104) in Kontakt steht, wobei die polykristalline Siliziumschicht (68) einen Rand (118) besitzt, der sich seitlich jenseits der Emitterzone (104) erstreckt,
Bilden einer zweiten Isolierschicht (84) auf dem Rand der polykristallinen Siliziumschicht (68),
Bilden einer Kollektorzone (90) in der Seite des Substrats (10) in Aus richtung mit der zweiten Isolierschicht (84), und
Eindiffundieren des Dotierstoffes der polykristallinen Siliziumschicht (68) in die Basiszone (54), um die Emitterzone (104) zu bilden.

20. Verfahren nach Anspruch 19, bei dem eine weitere Isolierschicht (82) auf einem zweiten Rand (76) der polykristallinen Siliziumschicht (68) gebildet wird und bei dem eine störstellenleitende Basiszone (100) in dem Substrat (10) in Ausrichtung mit der weiteren Isolierschicht (82) angrenzend an die Basiszone (54) gebildet wird.

## Revendications

1. Procédé de fabrication d'un transistor bipolaire comprenant les étapes suivantes
formation d'un puits semi-conducteur (22) d'un premier type de conductivité à la surface d'un substrat de silicium semi-conducteur (10) ;
formation d'une zone semi-conductrice de base (54) d'un deuxième type de conductivité à la surface dudit puits semi-conducteur (22) ;
formation d'une structure d'émetteur en silicium polycristallin (68) dudit premier type de conductivité en contact avec ladite zone semi-conductrice de base (54), ladite structure d'émetteur (68) ayant des parois latérales (76, 78) et étant munie d'une impureté dudit premier type de conductivité ;
formation d'une isolation (82, 84) sur lesdites parois latérales (76, 78) de ladite structure d'émetteur en silicium polycristallin (68) ;
formation d'une zone semi-conductrice de collecteur (90) d'un premier type de conductivité dans une première zone dudit puits (22) et auto-alignée par rapport à ladite isolation (84) pour ladite structure d'émetteur (68) ;
formation d'une zone extrinsèque de base (100) dudit deuxième type de conductivité dans une deuxième zone dudit puits (22) et auto-alignée par rapport à ladite isolation (82) pour ladite structure d'émetteur (68), ladite zone extrinsèque de base (100) étant contiguë à ladite zone semi-conductrice de base (54) ; et
diffusion d'une impureté dudit premier type de conductivité depuis ladite structure d'émetteur en silicium polycristallin (68) vers ladite zone de base (54) afin d'y former une zone semi-conductrice d'émetteur (104) dudit premier type de conductivité.

2. Procédé selon la revendication 1, comprenant en outre la formation d'un matériau de couche d'arrêt temporaire recouvrant ladite structure d'émetteur (68) afin d'empêcher des impuretés non souhaitées d'un type de conductivité opposé de pénétrer dans ladite structure d'émetteur (68).

3. Procédé selon la revendication 1, comprenant en outre la formation d'une couche isolante (44) entre ladite structure d'émetteur (68) et ladite zone semi-conductrice de base (54), la formation d'une ouverture dans ladite couche isolante (44) et la formation de ladite structure d'émetteur (68) à travers ladite ouverture en contact avec ladite zone semi-conductrice de base.

4. Procédé selon la revendication 1, comprenant en outre la formation de ladite zone de base (54) et de ladite zone de collecteur (90) à la surface dudit substrat semi-conducteur (10) et la formation d'un siliciure conducteur (106, 108, 110) recouvrant ladite zone de base (100), ladite zone de collecteur (90) et une portion de ladite structure d'émetteur en silicium polycristallin (68) afin de fournir des surfaces de contact électrique.

5. Procédé selon la revendication 4, comprenant en outre la formation d'une portion (146) dudit puits semi-conducteur (22) à la surface dudit substrat semi-conducteur (10) adjacent à ladite zone extrinsèque de base (100) et formant un revêtement métallique (148) recouvrant une portion à la fois dudit puits semi-conducteur (146) et de ladite zone extrinsèque de base (100) afin de former ainsi une diode d'arrêt en parallèle avec une jonction base-collecteur dudit transistor bipolaire.

6. Procédé selon la revendication 3, comprenant en outre la formation d'un isolant de porte pour dispositif MOSFET avec l'isolation de ladite couche isolante (44), et la formation d'un conducteur de porte avec le matériau de ladite structure d'émetteur (68).

7. Procédé selon la revendication 6, comprenant en outre la formation dudit isolateur de porte à l'instant même où est formée ladite couche isolante d'émetteur (44), et la formation dudit conducteur de porte à l'instant même où est formée ladite structure d'émetteur (68).

8. Procédé selon la revendication 6, comprenant en outre la formation d'une isolation de paroi latérale (82, 84) sur ladite structure d'émetteur (68) au même instant et avec les mêmes étapes que celles avec lesquelles est formée l'isolation correspondante de paroi latérale sur ledit conducteur de porte.

9. Procédé selon la revendication 6, comprenant en outre la formation d'une zone de source et de drain d'un premier type de dispositif MOSFET quand est formée ladite zone extrinsèque de base (100), et la formation de zones de source et de drain d'un deuxième type de dispositif MOSFET quand est formée ladite zone de collecteur.

10. Transistor bipolaire au silicium, comprenant :
un puits semi-conducteur (22) d'un premier type de conductivité ;
une bande conductrice de silicium polycristallin (62) recouvrant ledit puits (22) et s'étendant sensiblement d'un de ses côtés jusqu'à l'autre, un côté de ladite bande conductrice de silicium polycristallin (62) s'étendant latéralement au-delà dudit puits semi-conducteur (22) ;
une zone intrinsèque semi-conductrice de base (54) d'un deuxième type de conductivité située sous ladite bande conductrice de silicium polycristallin (62) ;
une zone semi-conductrice d'émetteur (68) en contact avec ladite bande d'émetteur en silicium polycristallin (62) et formée dans ladite zone intrinsèque de base (54) ;
une zone extrinsèque de base (100) et une zone de collecteur (90) formées sur des côtés opposés de ladite bande d'émetteur en silicium polycristallin (62), ladite zone extrinsèque de base (100) et ladite zone de collecteur (90) étant formées en contact électrique avec ladite région intrinsèque de base (54) ; et
une couche isolante (44) entre ladite bande d'émetteur en silicium polycristallin (68) et ladite zone intrinsèque de base (54) et une ouverture dans ladite zone intrinsèque de base (54) et une ouverture dans ladite couche isolante (44) à travers lesquelles est formée ladite bande d'émetteur en silicium polycristallin (68) en contact avec ladite zone de base (54).

11. Transistor bipolaire selon la revendication 10, comprenant en outre des électrodes respectives (116, 114) formées en contact avec ladite zone extrinsèque de base (100), avec ladite zone de collecteur (90) et avec la portion de ladite bande d'émetteur en silicium polycristallin (68) s'étendant latéralement-au-delà dudit puits semi-conducteur (22).

12. Transistor bipolaire selon la revendication 10, comprenant en outre un émetteur enterré et emboîté (68) comprenant une zone d'émetteur (104) formée dans ladite zone intrinsèque de base (54) et ayant une largeur inférieure à celle de la bande correspondante de ladite bande d'émetteur en silicium polycristallin.

13. Transistor bipolaire selon la revendication 10, comprenant en outre un émetteur muni de parois (128) comprenant ladite bande d'émetteur en silicium polycristallin (126) en contact avec ladite zone de base (54), ledit émetteur muni de parois (128) ayant une largeur sensiblement égale à la largeur correspondante de ladite bande d'émetteur en silicium polycristallin (126).

14. Transistor bipolaire selon la revendication 10, comprenant en outre une isolation de paroi latérale (82, 84) sur ladite bande d'émetteur en silicium polycristallin (68), et dans lequel ladite zone extrinsèque de base (100) et lesdites zones de collecteur (90) sont auto-alignées par rapport à ladite isolation de paroi latérale (82, 84).

15. Transistor bipolaire latéral au silicium ayant des régions de conductivités opposées, comprenant :
un puits d'impureté (22) d'un premier type de conductivité ;
une zone semi-conductrice de base (54) d'un deuxième type de conductivité formée dans ledit puits d'impureté (22) dudit premier type de conductivité ;
une zone semi-conductrice d'émetteur (104) dudit premier type de conductivité formee à l'intérieur de ladite zone de base (54) ;
un conducteur en silicium polycristallin (68) en contact électrique avec ladite zone d'émetteur (104) ;
de l'oxyde de silicium (82, 84) formé sur des parois latérales (76, 78) dudit conducteur en silicium polycristallin (68) ;
une zone semi-conductrice de collecteur (90) dudit premier type de conductivité formée dans ledit puits d'impureté (22) et auto-alignée avec ladite isolation de paroi latérale (82, 84) ; et
une zone extrinsèque de base (100) dudit type de conductivité formée dans ledit puits d'impureté (22) et autoalignée avec ladite isolation de paroi latérale (82) ;
dans lequel ladite zone de collecteur (90) et ladite zone extrinsèque de base (100) sont formées sur des côtés opposés dudit conducteur en silicium polycristallin (68).

16. Transistor bipolaire latéral selon la revendication 15, comprenant en outre un contact enterré (68) formé là où ladite zone d'émetteur (104) est en contact électrique avec ledit conducteur en silicium polycristallin (68), et comprenant en outre un contact (122) décalé latéralement par rapport audit contact enterré (68) pour assurer le contact électrique externe avec ledit conducteur en silicium polycristallin (68).

17. Transistor bipolaire latéral selon la revendication 16, dans lequel ledit contact enterré (68) est d'une largeur inférieure à la largeur correspondante de la portion de conducteur en silicium polycristallin recouvrant ledit contact enterré (68).

18. Transistor bipolaire latéral selon la revendication 16, dans lequel ledit conducteur en silicium polycristallin (118) est de forme allongée et s'étend au-delà dudit puits d'impureté (22), et ledit contact décalé (122) est disposé à proximité d'une extrémité dudit conducteur en silicium polycristallin (118).

19. Procédé pour former des zones semi-conductrices auto-alignees dans un transistor bipolaire, comprenant :
la formation d'une zone semi-conductrice de base (54) à la surface d'un substrat en silicium (10) ;
la formation d'une couche isolante (44) ayant une ouverture sur la zone semi-conductrice de base (54) ;
la formation d'une couche de silicium polycristallin dopé (68) recouvrant ladite couche isolante (44) et en contact avec ladite zone de base (54) à travers ladite ouverture afin de définir une zone d'émetteur (104), ladite couche de silicium polycristallin (68) ayant un rebord (118) s'étendant latéralement au-delà de ladite région d'émetteur (104) ;
la formation d'une deuxième couche isolante (84) sur ledit rebord de ladite couche de silicium polycristallin (68) ;
la formation d'une zone de collecteur (90) dans la face dudit substrat (10) alignée avec ladite deuxième couche isolante (84) ; et
la diffusion du dopant de ladite couche de silicium polycristallin (68) dans ladite zone de base (54) pour former ladite région d'émetteur (104).

20. Procédé selon la revendication 19, comprenant en outre la formation d'une couche isolante supplémentaire (82) sur un deuxième rebord (76) de ladite couche de silicium polycristallin (68) et la formation d'une zone extrinsèque de base (100) dans ledit substrat (10) alignée avec ladite couche isolante supplémentaire (82) et contiguë à ladite zone de base (54).
